# EUROPEAN PATENT APPLICATION

(11) **EP 2 551 916 A1**
(43) Date of publication of application: **30.01.2013**
(21) Application number: 11759151.1
(22) Date of filing: 28.02.2011
(51) Int. Cl.: H01L 31/04

(54) **PHOTOELECTRIC CONVERSION DEVICE AND METHOD FOR MANUFACTURING PHOTOELECTRIC CONVERSION DEVICE**

(30) Priority: 25.03.2010 JP 2010069761
(71) Applicant: Kyocera Corporation, Kyoto-shi, Kyoto 612-8501 (JP)
(72) Inventor: YAMADA Kazuki, Higashiomi-shi Shiga 527-8555 (JP); TANAKA Isamu, Higashiomi-shi Shiga 527-8555 (JP); INAI Seiichiro, Higashiomi-shi Shiga 527-8555 (JP)
(74) Representative: Witte, Weller & Partner
(86) International application number: PCT/JP2011/054494
(87) International publication number: WO 2011/118343

(57) **Abstract**

It is aimed to provide a photoelectric conversion device having improved conversion efficiency, and a method for manufacturing the photoelectric conversion device. For achieving this object, a photoelectric conversion device including a first semiconductor layer and a second semiconductor layer is employed. In the photoelectric conversion device, the first semiconductor layer includes one principal surface on which a plurality of projections are scattered, includes a I-III-VI group compound semiconductor, and has a first conductivity type. The second semiconductor layer is disposed on the one principal surface, has a thickness in a normal direction of the one principal surface, and has a second conductivity type different from the first conductivity type. Further, a first distance along which each of the projections is projected in the normal direction is longer than a second distance along which the second semiconductor layer is provided in the normal direction.

## Description

### TECHNICAL FIELD

The present invention relates to a photoelectric conversion device and a method for manufacturing the photoelectric conversion device.

### BACKGROUND ART

Solar cells include those using a photoelectric conversion device including a light absorbing layer comprised principally of a I-III-VI group compound semiconductor (see, for example, Patent Document 1). The I-III-VI group compound semiconductor is a chalcopyrite-based compound semiconductor such as CIGS. CIGS has a high optical absorption coefficient, and is suitable for thinning of the photoelectric conversion device, increasing of the area thereof and reduction of production costs thereof.

In this photoelectric conversion device, a plurality of photoelectric conversion cells are planarly provided side by side. In each photoelectric conversion cell, a lower electrode comprised principally of a metallic electrode and the like, a photoelectric conversion layer comprised of a semiconductor layer that principally includes a light absorbing layer, a buffer layer and the like, and an upper electrode comprised principally of a transparent electrode, a metallic electrode and the like are stacked in this order on a substrate such as a glass. Also, the plurality of photoelectric conversion cells are electrically connected in series by electrically connecting the upper electrode of one of adjacent photoelectric conversion cells and the lower electrode of the other photoelectric conversion cell by a connection conductor.

### PRIOR ART DOCUMENT

### PATENT DOCUMENT

Patent Document 1: Japanese Patent Application Laid-Open No. 2007-311578

### SUMMARY OF THE INVENTION

### PROBLEM TO BE SOLVED BY THE INVENTION

For Chalcopyrite-based photoelectric conversion devices, there is an intention of improving the conversion efficiency.

Thus, a photoelectric conversion device having improved conversion efficiency, and a method for manufacturing the photoelectric conversion device are desired.

### MEANS FOR SOLVING THE PROBLEM

For solving the above problem, a photoelectric conversion device according to a first aspect comprises a first semiconductor layer and a second semiconductor layer. In the photoelectric conversion device, the first semiconductor layer includes one principal surface on which a plurality of projections are scattered, includes a I-III-VI group compound semiconductor, and has a first conductivity type. The second semiconductor layer is disposed on the one principal surface, has a thickness in a normal direction of the one principal surface, and has a second conductivity type different from the first conductivity type. Further, a first distance along which each of the projections is projected in the normal direction is longer than a second distance along which the second semiconductor layer is provided in the normal direction.

A method for manufacturing the photoelectric conversion device according to a second aspect comprises the steps of: forming a film by applying a raw material solution onto an electrode layer; and forming a semiconductor layer by heat-treating the film. The raw material solution includes a Lewis-basic organic compound, an organic compound containing a chalcogen element, a I-B group element and a III-B group element which has an amount of substance greater than that of the I-B group element. The semiconductor layer includes one principal surface on which a plurality of projections are scattered, and includes a I-III-VI group compound semiconductor.

### ADVANTAGE OF THE INVENTION

According to the aspects of the present invention, light incident to a photoelectric conversion device is scattered and applied to various faces of a first semiconductor layer. As a result, the conversion efficiency in the photoelectric conversion device is improved.

### BRIEF DESCRIPTION OF THE DRAWINGS

Fig. 1 is a schematic view showing a state of a photoelectric conversion device according to one embodiment when viewed from above.
Fig. 2 is a schematic view showing a cross section of the photoelectric conversion device along a section line II-II in Fig. 1.
Fig. 3 is a schematic view in which a part of one principal surface of a light absorbing layer is shown in a magnified form.
Fig. 4 is a sectional view schematically showing a projection and a periphery thereof.
Fig. 5 is a sectional view schematically showing a pinhole and a periphery thereof in a photoelectric conversion layer.
Fig. 6 is a SEM photograph showing a specific example of a formation form of the photoelectric conversion layer including a pinhole.
Fig. 7 is a sectional view showing a state of the photoelectric conversion device in the course of manufacture.
Fig. 8 is a sectional view showing a state of the photoelectric conversion device in the course of manufacture.
Fig. 9 is a sectional view showing a state of the photoelectric conversion device in the course of manufacture.
Fig. 10 is a sectional view showing a state of the photoelectric conversion device in the course of manufacture.
Fig. 11 is a sectional view showing a state of the photoelectric conversion device in the course of manufacture.
Fig. 12 is a sectional view showing a state of the photoelectric conversion device in the course of manufacture.
Fig. 13 is a SEM photograph showing a specific example of one principal surface of the light absorbing layer on which projections are scattered.

### EMBODIMENT FOR CARRYING OUT THE INVENTION

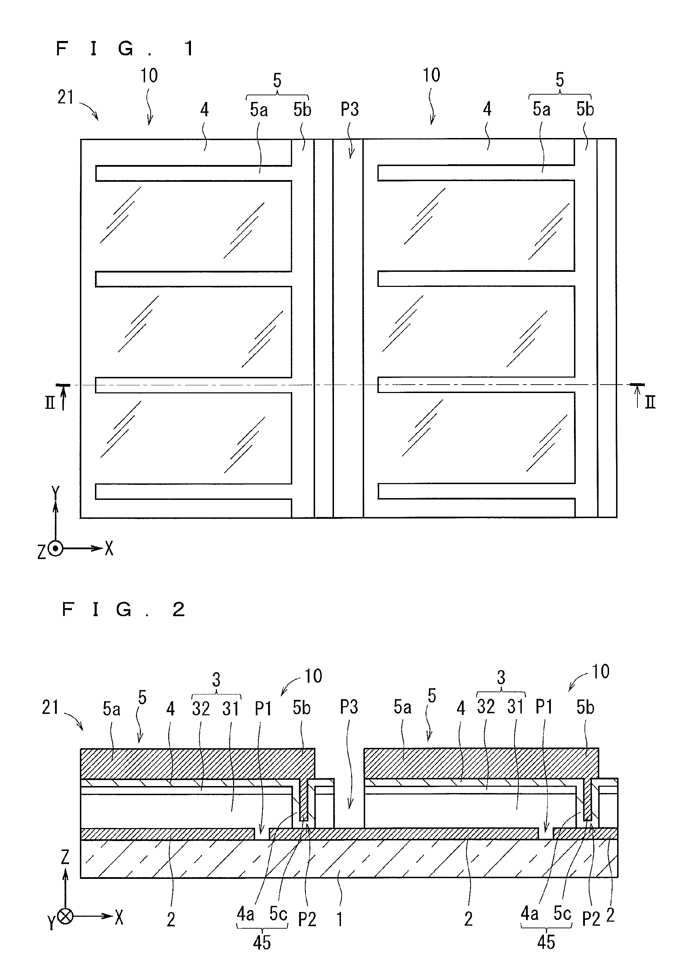

Hereinbelow, one embodiment of the present invention will be described based on the drawings. In the drawings, parts having similar configurations and functions are given same symbols, and duplicate explanations will be omitted in the description below. The drawings are schematically shown, and the size, the positional relation and the like of various configurations in each drawing are not accurately shown. Figs. 1 to 5 and Figs. 7 to 12 are each given a right-handed XYZ coordinate system where a direction along which photoelectric conversion cells 10 are arranged (crosswise direction in the view of the drawing in Fig. 1) is set to the X-axis direction.

### <(1) Configuration of Photoelectric Conversion Device>

A photoelectric conversion device 21 comprises a substrate 1 and a plurality of photoelectric conversion cells 10 which are planarly arranged on the substrate 1. Fig. 1 shows only a part of two photoelectric conversion cells 10 for convenience of representation. However, in the actual photoelectric conversion device 21, multiple photoelectric conversion cells 10 can be planarly arranged in the crosswise direction of the drawing.

Each of the photoelectric conversion cells 10 includes a lower electrode layer 2, a photoelectric conversion layer 3, an upper electrode layer 4, a grid electrode 5 and a connector 45. In the photoelectric conversion device 21, a principal surface provided with the upper electrode layer 4 and the grid electrode 5 is a light receiving surface. Furthermore, the photoelectric conversion device 21 is provided with three kinds of grooves, i.e. a first groove P1, a second groove P2 and a third groove P3.

A substrate 1 supports the plurality of photoelectric conversion cells 10. As a material that is used for the substrate 1, for example, a glass, a ceramic, a resin, a metal and the like can be employed. In this embodiment, the substrate 1 is a blue plate glass (soda lime glass) having a thickness of approximately not less than 1 mm and not more than 3 mm.

The lower electrode layer 2 is a conductive layer provided on a principal surface (also referred to as one principal surface) of the substrate 1 at the +Z side. As main materials included in the lower electrode layer 2, for example, various kinds of conductive metals such as Mo, A1, Ti, Ta and Au can be employed. Further, it is sufficient that the thickness of the lower electrode layer 2 is, for example, approximately not less than 0.2 µm and not more than 1 µm. The lower electrode layer 2 can be formed by, for example, a known method for forming a thin film, such as a sputtering method or vapor deposition method.

The photoelectric conversion layer 3 includes a light absorbing layer 31 and a buffer layer 32. The light absorbing layer 31 and the buffer layer 32 are laminated.

The light absorbing layer 31 is provided on a principal surface (also referred to as one principal surface) of the lower electrode layer 2 at the +Z side, and includes a semiconductor having a first conductivity type. Here, the first conductivity type is a p type. It is sufficient that the thickness of the light absorbing layer 31 is, for example, approximately not less than 1 µm and not more than 3 µm. If the light absorbing layer 31 is a layer of a I-III-VI group compound semiconductor that is a chalcopyrite-based (also referred to as CIS-based) compound semiconductor, the conversion efficiency can be improved even though the thickness of the light absorbing layer 31 is small. Consequently, the light absorbing layer 31 can be produced with a small amount of materials at a low cost. In this embodiment, the light absorbing layer 31 is a layer of a I-III-VI group compound semiconductor having a conductivity type of p type.

The I-III-VI group compound semiconductor is a semiconductor that principally contains a I-III-VI group compound. The semiconductor that principally contains a I-III-VI group compound means that the semiconductor contains 70 mol% or more of I-III-VI group compound. Also in the description below, "principally contain(s)" means "contain(s) 70 mol% or more". The I-III-VI group compound is a compound that principally contains a I-B group element (also referred to as 11 group element), a III-B group element (also referred to as 13 group element) and a VI-B group element (also referred to as 16 group element). As the I-III-VI group compound, for example, CuInSe₂ (also referred to as CIS), Cu(In, Ga)Se₂ (also referred to as CIGS), Cu(In, Ga)(Se, S)₂ (also referred to as CIGSS) and the like can be employed. Cu(In, Ga)Se₂ is a compound that principally contains Cu, In, Ga and Se. Further, Cu(In, Ga)(Se, S)₂ is a compound that principally contains Cu, In, Ga, Se and S. The light absorbing layer 31 may be a thin film of a multinary compound semiconductor such as Cu(In, Ga)Se₂ provided with, as a surface layer, Cu(In, Ga)(Se, S)₂ in the form of a thin film.

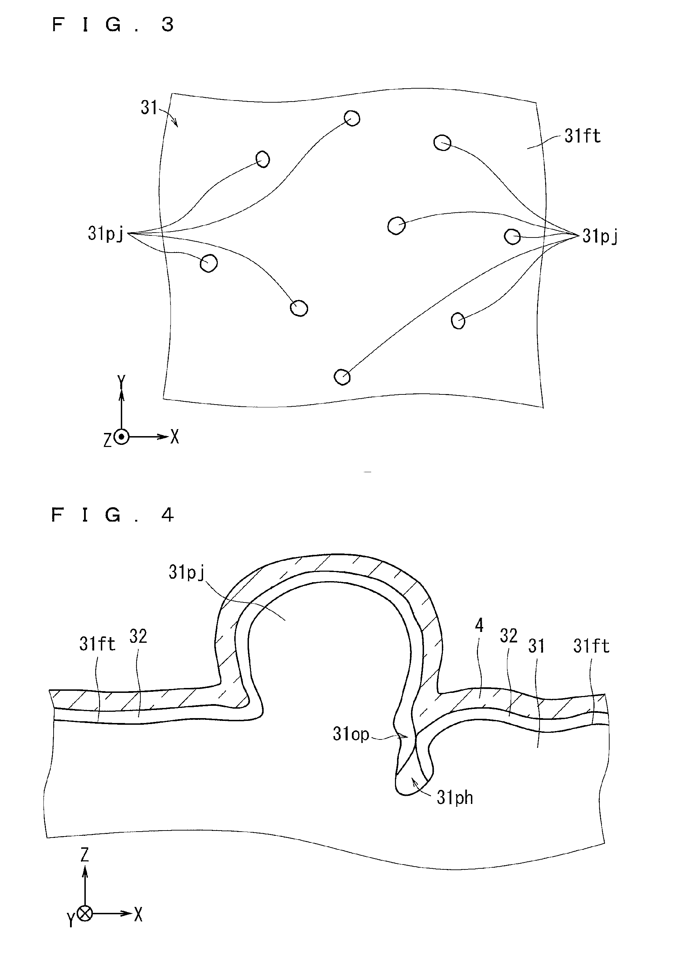

A plurality of projections 31pj (see Fig. 3) are scattered on a principal surface (also referred to as one principal surface) at the buffer layer 32 side (+Z side in the figure) of the light absorbing layer 31 as a first semiconductor layer. It is sufficient that the projection 31pj principally contains a I-III-VI group compound same as that of the light absorbing layer 31 or a high-resistance compound having a resistivity higher than that of the I-III-VI group compound, such as a III-VI group compound. If the material of the projection 31pj principally contains a high-resistance compound, generation of a leak current resulting from electric connection of the light absorbing layer 31 and the upper electrode layer 4 is reduced even if a pinhole occurs in the buffer layer 32 formed on the surface of the projection 31pj. As a result, the conversion efficiency in the photoelectric conversion device 21 is improved. Particularly, it is sufficient that the material of the projection 31pj is a III-VI group compound which is a part of the composition of the light absorbing layer 31. In this case, the material of the light absorbing layer 31 is similar to the material of the projection 31pj, and therefore the projection 31pj and the light absorbing layer 31 are nicely bonded together. Moreover, the III-VI group compound has a high resistivity in comparison with the I-III-VI group compound, and therefore generation of a leak current is effectively reduced. The III-VI group compound is a compound that principally contains a III-B group element and a VI-B group element. As the III-VI group compound, for example, In₂Se₃, Ga₂Se₃ and the like can be employed.

The projection 31pj is a portion which prominently projects from a flat surface (also referred to as reference surface) 31ft in one principal surface of the light absorbing layer 31. The reference surface 31ft may be a substantially flat surface that is slightly rough. It is sufficient that the outer diameter and the height of the projection 31pj is, for example, not less than about 1 µm and not more than about 100 µm, which is greater than a wavelength band of not less than about 400 nm and not more than about 900 nm, i.e. the wavelength band of visible light included in sunlight. As a result of scattering of the projections 31pj, visible light and light having a wavelength below the wavelength band of the visible light, both of which are included in sunlight, are reflected at the surface of the projection 31pj in various directions. As a result, sunlight is scattered and applied to various faces of the light absorbing layer 31, so that the conversion efficiency in the photoelectric conversion device 21 is improved.

Here, the height of the projection 31pj is a distance along which the projection 31pj projects in the +Z direction relative to the position of the reference surface 31ft. In other words, the height of the projection 31pj is a distance (also referred to as projecting distance) provided such that the projection 31pj projects along the normal direction (herein +Z direction) of the reference surface 31ft. As the position of the reference surface 31ft, for example, an average value of Z coordinates in a predetermined range (for example, a region of several µm square) surrounding the projection 31pj, or the like can be employed. As a method for measuring the height of the projection 31pj, for example, a method can be employed in which the projection 31pj is subjected to cross-section polisher (CP) processing, followed by observing the cross section of the projection 31pj by SEM to measure the height of the projection 31pj. Further, as the outer diameter of the projection 31pj, for example, any of an average value of the diameters of XY cross sections of projections 31pj, the diameter of the inscribed circle of this XY cross section and the diameter of circumscribed circle of this XY cross section may be employed. As a method for measuring the diameter of the projection 31pj, for example, a method can be employed in which one principal surface of the light absorbing layer 31 is observed by SEM to measure the diameter of the projection 31pj.

Here, the adhesion between the light absorbing layer 31 and the buffer layer 32 is adequately provided if the ratio of projections 31pj to one principal surface of the light absorbing layer 31 is several tens of percents or less. Namely, it is sufficient that projections 31pj are moderately scattered on one principal surface of the light absorbing layer 31. Projections 31pj may be scattered on the light absorbing layer 31 at a ratio ranging from 0.0001 to 0.01 projections / µm² from the viewpoint of nicely forming the buffer layer 32 on the light absorbing layer 31 to provide good electric connection.

The light absorbing layer 31 can be formed by a process so called a coating method or printing method. In the coating method, a raw material solution containing a complex of a constituent element of the light absorbing layer 31 is applied onto the lower electrode layer 2, followed by drying and heat treatment sequentially.

The buffer layer 32 is a semiconductor layer provided on one principal surface of the light absorbing layer 31. This semiconductor layer has a conductivity type different from the conductivity type of the light absorbing layer 31. Here, the different conductivity type is an n type. Further, the buffer layer 32 and the light absorbing layer 31 form a hetero-junction region. In the photoelectric conversion cell 10, photoelectric conversion occurs in the photoelectric conversion layer 3 in which the light absorbing layer 31 and the buffer layer 32 are laminated. Semiconductors having different conductivity types refer to semiconductors having different conduction carriers (carriers). If the conductivity type of the light absorbing layer 31 is a p type, the conductivity type of the buffer layer 32 may be not an n type but an i type. Further, the conductivity type of the light absorbing layer 31 is an n or i type, the conductivity type of the buffer layer 32 may be a p type.

The buffer layer 32 principally contains a compound semiconductor. As the compound semiconductor contained in the buffer layer 32, for example, CdS, In₂S₃, ZnS, ZnO, In₂Se₃, In(OH,S), (Zn,In)(Se,OH), (Zn,Mg)O and the like can be employed. If the resistivity of the buffer layer 32 is 1Ω·cm or more, the leak current is reduced. The buffer layer 32 can be formed by, for example, a chemical bath deposition (CBD) method and the like.

The thickness direction of the buffer layer 32 substantially coincides with the normal direction of one principal surface of the light absorbing layer 31. It is sufficient that the thickness of the buffer layer 32 is, for example, not less than 10 nm and not more than 200 nm. If the thickness of the buffer layer 32 is not less than 100 nm and not more than 200 nm, a reduction in conversion efficiency under conditions of a high temperature and a high humidity can be remarkably mitigated. In this case, the projecting distance of the projection 31pj in the light absorbing layer 31 is longer than a distance along which the buffer layer 32 is provided in the normal direction of one principal surface (specifically the reference surface 31ft) of the light absorbing layer 31 (corresponding to the thickness of the buffer layer 32). From another viewpoint, when a comparison is made in the same unit of length (e.g. nm), a value showing the height of the projection 31pj in the +Z direction, relative to the position of the reference surface 31ft of the light absorbing layer 31, is greater than a value showing the thickness of the buffer layer 32 in the +Z direction. As a specific method for measuring the thickness of the buffer layer 32, for example, a method can be employed in which the cross section of the buffer layer 32 is observed by TEM to measure the thickness of the buffer layer 32.

Accordingly, as shown in Fig. 4, the buffer layer 32 is formed along the shape of the reference surface 31ft and the projection 31pj, and the shape of the principal surface of the buffer layer 32 at the upper electrode layer 4 side is influenced by the shape of one principal surface of the light absorbing layer 31. That is, also in the principal surface of the buffer layer 32 at the upper electrode layer 4 side, projections projecting in the +Z direction are generated right over the projections 31pj. Owing to the presence of this projection, visible light and light having a wavelength below the wavelength band of the visible light, both of which are included in sunlight, are reflected at the surface of the projection in various directions and refracted at the boundary area between the buffer layer 32 and the projection 31pj. As a result, sunlight is scattered and applied to various faces of the light absorbing layer 31, so that the conversion efficiency in the photoelectric conversion device 21 is further improved. Also in the upper electrode layer 4, projections are generated on the principal surface at the +Z side, and reflection and refraction of sunlight are thus promoted. Consequently, sunlight is further scattered, so that the conversion efficiency in the photoelectric conversion device 21 is further improved.

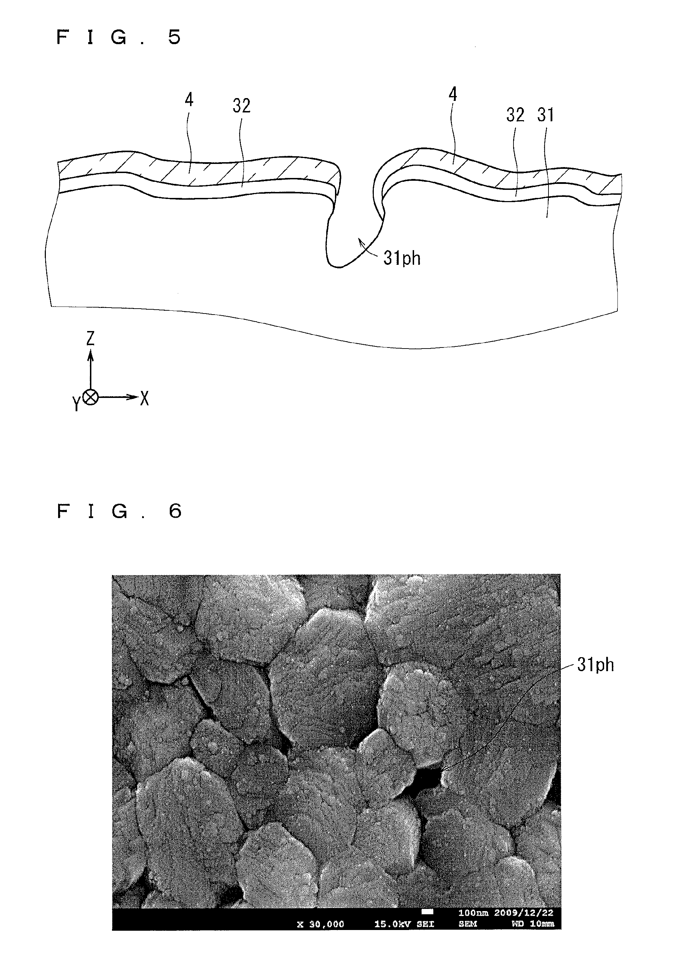

Here, if the light absorbing layer 31, the buffer layer 32 and the upper electrode layer 4 are sequentially formed by vapor deposition or the like, a pinhole 31ph as a hole can occur in one principal surface of the light absorbing layer 31 as shown in Figs. 5 and 6. At this time, there is a concern that the pinhole 31ph is not sufficiently filled with the buffer layer 32, and the light absorbing layer 31 and at least one of the upper electrode layer 4 and the grid electrode 5 contact each other to generate so called a leak current, leading to a reduction in conversion efficiency.

In contrast to this, in the photoelectric conversion device 21 according to this embodiment, the projection 31pj may be present in the vicinity of the pinhole 31ph as shown in Fig. 4. In this case, an opening 31op of the pinhole 31ph tends to be closed by the buffer layer 32. Accordingly, contact between the light absorbing layer 31 and at least one of the upper electrode layer 4 and the grid electrode 5 is avoided where possible. Thus, even though other layer or the like for embedding the pinhole 31ph is not formed, generation of a leak current can be reduced to improve the conversion efficiency.

Here, it is sufficient that the height of the projection 31pj is, for example, not less than twice and not more than 1000 times the diameter of the opening 31op (also referred to as opening diameter) in the pinhole 31ph. Consequently, the opening diameter in the pinhole 31 ph is as small as approximately not less than 10 nm and not more than 50 nm, and the opening 31op can be closed by the buffer layer 32.

The upper electrode layer 4 is provided on a principal surface (also referred to as one principal surface) of the buffer layer 32 at the +Z side. This upper electrode layer 4 is, for example, a transparent conductive film (also referred to as transparent electrode layer) having a conductivity type of n type. The upper electrode layer 4 is an electrode (also referred to as take-out electrode) which takes out electrical charges generated in the photoelectric conversion layer 3. Further, a material principally contained in the upper electrode layer 4 has a resistivity lower than that of the buffer layer 32. The upper electrode layer 4 may contain so called a window layer or may contain a window layer and a transparent conductive film.

The upper electrode layer 4 principally contains a material which has a wide band gap, is transparent and has a low resistance. As such a material, for example, ZnO, a compound of zinc oxide, ITO (indium tin oxide) containing Sn, a metal oxide semiconductor such as SnO₂, and the like can be employed. The compound of zinc oxide contains any one of A1, B, Ga, In and F elements, and the like.

The upper electrode 4 can be formed by a sputtering method, a vapor deposition method, a chemical vapor deposition (CVD) method or the like. It is sufficient that the thickness of the upper electrode layer 4 is, for example, not less than 0.05 µm and not more than 3.0 µm. Here, if the upper electrode layer 4 has, for example, a resistivity of less than 1Ω·cm and a sheet resistance of 50Ω/□ or less, electrical charges can be nicely taken out from the photoelectric conversion layer 3 through the upper electrode layer 4.

If the buffer layer 32 and the upper electrode layer 4 have such a nature that light is easily transmitted (also referred to as optical transparency) over a wavelength band of light that can be absorbed by the light absorbing layer 31, a reduction in light absorption efficiency in the light absorbing layer 31 can be mitigated.

If the thickness of the upper electrode layer 4 is not less than 0.05 µm and not more than 0.5 µm, the optical transparency in the upper electrode layer 4 is improved, and a current generated by photoelectric conversion can be nicely transmitted. Further, if the absolute refractive index of the upper electrode layer 4 is substantially the same as the absolute refractive index of the buffer layer 32, losses of incident light caused by reflection of light at the boundary between the upper electrode layer 4 and the buffer layer 32 are reduced.

The grid electrode 5 is a conductive linear electrode part provided on a principal surface (also referred to as one principal surface) of the upper electrode layer 4 at the +Z side. This grid electrode 5 includes a plurality of collectors 5a and a coupler 5b. The plurality of collectors 5a are provided at a distance from one another in the Y-axis direction, and each extends in the X-axis direction. The coupler 5b, to which collectors 5a are connected, extends in the Y-axis direction. As a material of the grid electrode 5, for example, a metal such as Ag can be employed. The metal contained in the grid electrode part 5 may be, for example, copper, aluminum, nickel and the like.

Collectors 5a collect electrical charges taken out by the upper electrode layer 4 after being generated in the photoelectric conversion layer 3. Provision of collectors 5a makes it possible to thin the upper electrode layer 4. The upper electrode layer 4 is provided above the light absorbing layer 31, and therefore the optical transparency in the upper electrode layer 4 can be improved if the upper electrode layer 4 is formed as thinly as possible. In the upper electrode 4, however, as the layer becomes thinner, the resistance increases, so that the electrical charge take-out efficiency is reduced. Thus, by provision of collectors 5a, the electrical charge take-out efficiency is secured, and it is possible to improve the optical transparency by the thinning of the upper electrode layer 4.

Electric charges collected by the grid electrode 5 and the upper electrode layer 4 are transmitted to the adjacent photoelectric conversion cell 10 through the connector 45 provided at the second groove P2. The connector 45 includes an extending part 4a of the upper electrode layer 4 and a suspending part 5c from the coupler 5b formed thereon. Consequently, in the photoelectric conversion device 21, the lower electrode layer 2 of one of adjacent photoelectric conversion cells 10 and the upper electrode layer 4 and the grid electrode 5 of the other photoelectric conversion cell 10 are electrically connected in series by the connector 45 as a connection conductor provided at the second groove P2.

If the width of the grid electrode 5 is not less than 50 µm and not more than 400 µm, a reduction in light receiving surface area affecting the amount of light incident to the light absorbing layer 31 can be mitigated while a good conductivity is secured.

The surface of at least the coupler 5b of the grid electrode 5 can be formed by, for example, a material that reflects light of a wavelength band absorbed by the light absorbing layer 31. In this case, when the photoelectric conversion device 21 is modulized, light reflected by the coupler 5b can be reflected again within the photoelectric conversion module and made incident to the light absorbing layer 31 again. Consequently, the amount of light incident to the light absorbing layer 31 increases, so that the conversion efficiency in the photoelectric conversion device 21 is improved. For such a surface to be formed, for example, it is sufficient that the grid electrode part 5 is formed by applying onto one principal surface of the upper electrode layer 4 a paste in which metallic particles such as Ag having a high light reflectivity are added to a optically transparent resin, and solidifying the paste by subsequent drying. Also, for example, a metal such as aluminum having a high light reflectivity may be deposited on the surface of the grid electrode part 5.

### <(2) Method for Manufacturing Photoelectric Conversion Device>

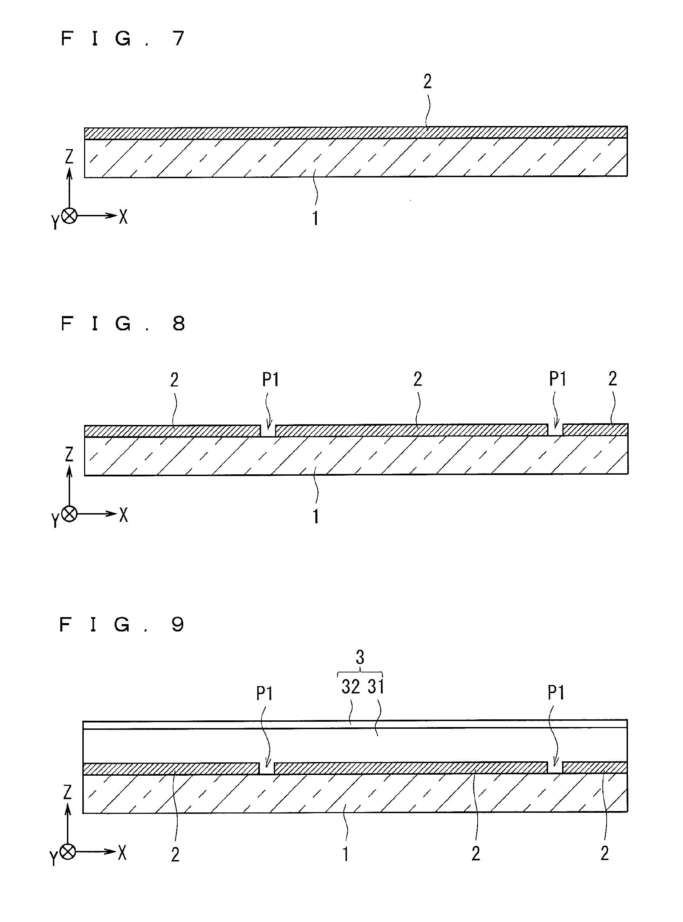

Sectional views shown in Figs. 7 to 12 each show a state in the course of manufacture regarding a part corresponding to the cross section of the photoelectric conversion device 21 shown in Fig. 2.

First, as shown in Fig. 7, the lower electrode layer 2 that principally contains Mo and the like is formed on substantially the entire surface of the cleaned substrate 1 by using a sputtering method or the like. The first groove P1 is formed to extend from a linear forming target position along the Y direction in the upper surface of the lower electrode layer 2 to the upper surface of the substrate 1 just below the above-mentioned position. The first groove P1 can be formed by, for example, scanning laser light from a YAG laser or the like while applying the laser light to the forming target position. Fig. 8 is a view showing a state after the first groove P1 is formed.

After the first groove P1 is formed, the light absorbing layer 31 and the buffer layer 32 are sequentially formed on the lower electrode layer 2. Fig. 9 is a view showing a state after the light absorbing layer 31 and the buffer layer 32 are formed.

The light absorbing layer 31 can be formed by applying onto the surface of the lower electrode layer 2 a raw material solution for forming the light absorbing layer 31, followed by carrying out drying and heat treatment sequentially. The raw material solution for forming the light absorbing layer 31 is prepared by dissolving a I-B group element and a III-B group element directly in a solvent (also referred to as a mixed solvent) containing a chalcogen element-containing organic compound and a basic organic solvent as a Lewis-basic organic compound. In this raw material solution, for example, the total concentration of the I-B group element and the III-B group element can be 10 percent by mass or more.

Here, the raw material solution is prepared such that the physical quantity of III-B group element is relatively greater than the physical quantity of I-B group element with reference to the composition (i.e. stoichiometric composition) ratio of the I-B group element to the III-B group element in the I-III-VI group compound semiconductor. Specifically, the raw material solution is adjusted so that the amount of substance of III-B group element that can contain In, Ga and the like is greater than the amount of substance of I-B group element that can contain Cu and the like. This raw material solution makes it possible to scatter projections 31pj on one principal surface of the light absorbing layer 31.

The chalcogen element-containing organic compound is an organic compound that principally contains a chalcogen element. The chalcogen element is S, Se and Te of VI-B elements. As the chalcogen element-containing organic compound, for example, thiol, sulfide, disulfide, selenol, selenide, diselenide and the like can be employed.

The Lewis-basic organic compound is an organic compound including a functional group which can be formed into a Lewis base. As the functional group which can be formed into a Lewis base, a functional group comprising a V-B group element (also referred to as 15 group element) including an unshared electron pair, a functional group including a VI-B group element including an unshared electron pair, and the like can be employed. As specific examples of these functional groups, for example, an amino group (that may be any of primary to tertiary amines), a carbonyl group, a cyano group and the like can be employed. As specific examples of Lewis-basic organic compounds, pyridine, aniline, triphenylphosphine, 2,4-pentanedione, 3-methyl-2, 4-pentanedione, triethylamine, triethanolamine, acetonitrile, benzyl, benzoin and the like, and derivatives thereof can be employed.

For example, first, phenylselenol as a chalcogen element-containing organic compound is dissolved at a ratio of 100 mol% to aniline as a Lewis-basic organic compound to prepare a mixed solvent. Next, a raw metal of Cu, a raw metal of In, a raw metal of Ga, and a raw metal of Se are each dissolved directly in this mixed solvent to prepare a raw material solution. Here, the process of dissolving a metal directly in a mixed solvent is a process of mixing a metal alone or a raw metal of alloy directly in a mixed solvent to be dissolved.

Then, the raw material solution is applied onto the surface of the lower electrode layer 2 by, for example, a blade method, and then dried, whereby a film can be formed. Thereafter, the film is heat-treated under an atmosphere of a mixed gas of a hydrogen gas and a selenium vapor gas, whereby the light absorbing layer 31 can be prepared.

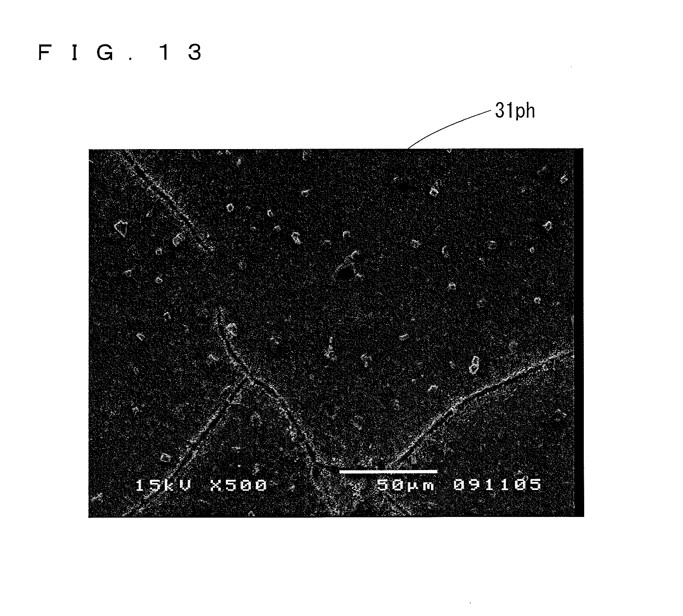

For application of the raw material solution, various methods, such as a spin coater, screen printing, dipping, spraying or a die coater can be used. It is sufficient that drying is carried out, for example, under a reducing atmosphere. It is sufficient that the drying temperature is, for example, not less than 50°C and not more than 300°C. In the heat treatment, for example, the temperature is elevated to 560°C at a relatively low temperature rising rate of 10°C per minute or less, and kept at 560°C for an hour, followed by cooling by natural convection (natural cooling). At this time, a I-III-VI group compound semiconductor is formed, an excessive III-B group element combines with a VI-B group element to precipitate a III-VI compound such as In₂Se₃ and Ga₂Se₃, and the projection 31pj are thereby formed. Fig. 13 is a SEM photograph showing a specific example of one principal surface of the light absorbing layer 31 on which a plurality of projections 31pj are scattered.

As a material of the projection 31pj, a I-III-VI group compound may be employed in place of a III-VI group compound. The projection 31pj that principally contains a 1-111-VI group compound can be prepared by, for example, carrying out the following steps (i) and (ii) sequentially. (i) A resist film provided with an opening for forming the projection 31pj is formed on a film from which the light absorbing layer 31 is formed. (ii) A raw material solution is filled in this opening and dried, followed by carrying out removal of the resist film and a heat treatment sequentially.

The buffer layer 32 can be formed by a chemical bath deposition method (CBD method). For example, the substrate 1 on which the light absorbing layer 31 and the preceding layers are formed is immersed in a solution obtained by dissolving cadmium acetate and thiourea in aqueous ammonia, whereby the buffer layer 32 that principally contains CdS can be formed.

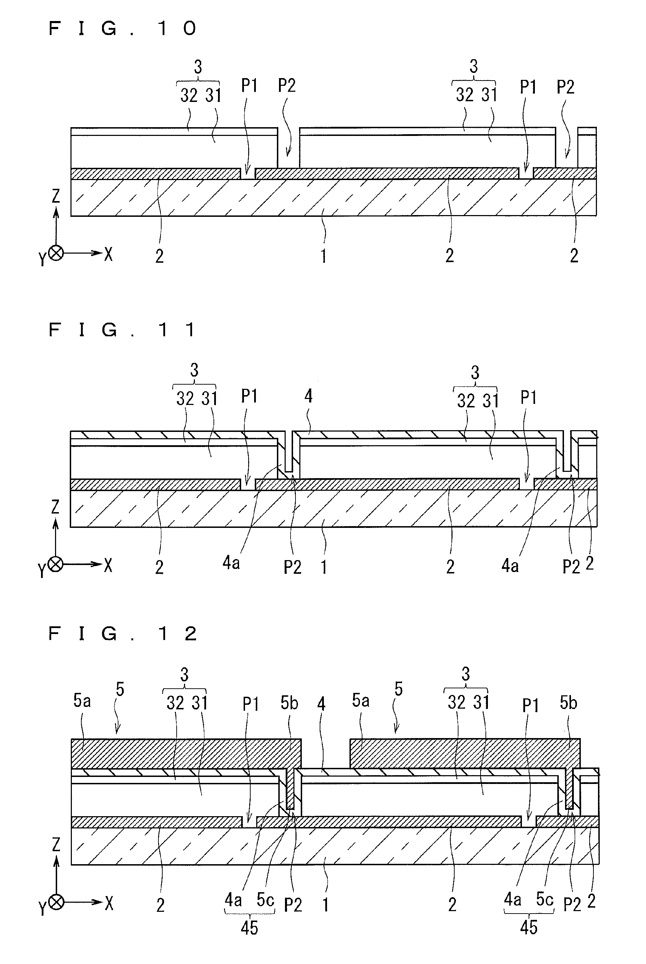

After the light absorbing layer 31 and the buffer layer 32 are formed, the second groove P2 is formed to extend from a linear forming target position along the Y direction in the upper surface of the buffer layer 32 to the upper surface of the lower electrode layer 2 just below the above-mentioned position. The second groove P2 is formed by, for example, carrying out scribing using a scribe needle having a scribe width of approximately not less than 40 µm and not more than 50 µm several times while shifting the position. The second groove P2 may also be formed by carrying out scribing with a scribe needle with its tip shape widened to a width close to that of the second groove P2. Alternatively, the second groove P2 may be formed by carrying out scribing one to several times with two or more scribe needles fixed in such a manner as to be pressed or abutted against one another. Fig. 10 is a view showing a state after the second groove P2 is formed. The second groove P2 is formed at a position that is slightly shifted in the X direction (+X direction in the drawing) from the first groove P1.

After the second groove P2 is formed, for example, the transparent upper electrode layer 4 containing ITO or the like as a main component is formed on the buffer layer 32. The upper electrode layer 4 can be formed by a sputtering method, a vapor deposition method, a CVD method or the like. Fig. 11 is a view showing a state after the upper electrode layer 4 is formed.

After the upper electrode 4 is formed, the grid electrode 5 is formed. The grid electrode 5 can be formed by, for example, printing a paste having a conductivity (also referred to as conductive paste), in which a metal powder such as Ag is dispersed in a resin binder or the like, so as to draw a desired pattern, and solidifying the same by drying. The solidified state includes both a solidified state after melting when the binder used for the conductive paste is a thermoplastic resin and a state after curing when the binder is a curable resin such as a thermosetting resin and a photo-curable resin. Fig. 12 is a view showing a state after the grid electrode 5 is formed.

After the grid electrode 5 is formed, the third groove P3 is formed to extend from a linear forming target position in the upper surface of the upper electrode layer 4 to the upper surface of the lower electrode layer 2 just below the above-mentioned position. Consequently, the photoelectric conversion device 21 shown in Figs. 1 and 2 is obtained. It is sufficient that the width of the third groove P3 is, for example, approximately not less than 40 µm and not more than 1000 µm. The third groove P3 can be formed by mechanical scribing as in the case of the second groove P2.

### <(3) Specific Examples>

Improvement of the photoelectric conversion device 21 by scattering projections 31pj will now be described by showing specific examples.

Here, five photoelectric conversion devices (specifically Examples 1 to 4 and Comparative Example) including a structure similar to that of the photoelectric conversion device 21 were prepared by forming semiconductor layers principally containing CIGS by using raw material solutions different in the ratio of contents of Cu, In and Ga.

Specifically, first, phenylselenol as a chalcogen element-containing organic compound was dissolved at a ratio of 100 mol% to aniline as a Lewis-basic organic compound to prepare a mixed solvent S. Next, a raw metal of Cu, a raw metal of In, a raw metal of Ga and a raw metal of Se were dissolved directly in the mixed solution S to prepare five raw material solutions containing the contents of Cu, In, Ga, and Se shown in Table 1, respectively. For these raw material solutions, ratios (molar ratios) of the amount of substance of the I-B group element (herein Cu) to the amount of substance of the III-B group element (herein In and Ga) were set to mutually different values. Specifically, five raw material solutions were prepared in which values obtained by dividing the amount of substance of Cu by the total value of the amounts of substance of In and Ga were 0.63, 0.72, 0.78, 0.90, and 1.0, respectively. These raw material solutions were designated as solutions for forming semiconductor layers principally containing CIGS.

**[Table 1]**

| | Example 1 | Example 2 | Example 3 | Example 4 | Comparative Example |
|---|---|---|---|---|---|
| Cu content (wt%) | 2.3 | 2.3 | 2.3 | 2.3 | 2.3 |
| In content (wt%) | 4.1 | 3.5 | 3.2 | 2.8 | 2.5 |
| Ga content (wt%) | 1.5 | 1.4 | 1.3 | 1.1 | 1.0 |
| Se content (wt%) | 7.2 | 7.2 | 7.2 | 7.2 | 7.2 |
| Molar ratio [amount of substance of Cu/( amount of substance of In + amount of substance of Ga)] | 0.63 | 0.72 | 0.78 | 0.90 | 1.0 |
| Presence/absence of projections | Present | Present | Present | Present | Absent |
| Conversion efficiency (%) | 8.8 | 12.1 | 11.4 | 10.2 | 5.3 |

Next, an article constituted such that the lower electrode layer 2 principally containing Mo and the like was formed on the surface of the substrate 1 principally containing a glass was prepared, and a raw material solution was applied onto the lower electrode layer 2 by a blade method and then dried to form a film. This film was formed by performing the process of carrying out application by the blade method and subsequent drying two times sequentially. Thereafter, a heat treatment was carried out under an atmosphere of a mixed gas of a hydrogen gas and a selenium vapor gas. In this heat treatment, the temperature was elevated to 560°C at a temperature rising rate of 10°C/min, and kept at 560°C for an hour, followed by natural cooling to form a semiconductor layer having a thickness of about 2 µm and principally containing CIGS. This semiconductor layer corresponds to a light absorbing layer.

Next, the substrate 1 on which the semiconductor layer and the preceding layers were formed was immersed in a solution obtained by dissolving cadmium acetate and thiourea in aqueous ammonia to form on the semiconductor layer a buffer layer having a thickness of about 50 nm and principally containing CdS. Further, a transparent conductive film doped with A1 and principally containing zinc oxide was formed on this buffer layer by a sputtering method. Finally, a take-out electrode principally containing A1 was formed by vapor deposition, thus preparing photoelectric conversion devices as examples 1 to 4 and Comparative Example, respectively.

For Examples 1 to 4 and Comparative Example, examinations were made regarding whether or not projections 31pj having a height of 1 µm or more were present on one principal surface at the buffer layer side of the semiconductor layer principally containing CIGS. The examination was carried out by observing the surface of the semiconductor layer with a scanning electron microscope (SEM) at the time when the semiconductor layer principally containing CIGS was formed, in the process of preparation of photoelectric conversion devices as Examples 1 to 4 and Comparative Example. The conversion efficiency in photoelectric conversion devices as Examples 1 to 4 and Comparative Example was measured by using so called a fixed light solar simulator under conditions where the radiation intensity of light to the light receiving surface of the photoelectric conversion device was 100 mW/cm² and the AM (air mass) was 1.5.

The results of examinations regarding presence/absence of projections 31pj and results of measurements of the conversion efficiency for photoelectric conversion devices as Examples 1 to 4 and Comparative Example are each shown in Table 1. The projections 31pj found in Examples 1 to 4 were estimated to principally contain a III-VI group compound containing In, Ga, and Se as a result of analysis using an EDX (energy-dispersive X-ray method) at the time of observation by SEM.

As shown in Table 1, it was found that projections 31jp having a height of 1 µm or more were scattered on one principal surface of the semiconductor layer principally containing CIGS for Examples 1 to 4. Particularly, for Examples 1 to 3, it was found that projections 31pj having a height of not less than 3 µm and not more than 5 µm were scattered in a density of not less than 0.002 projections/µm² and not more than 0.003 projections/µm². On the other hand, projections 31pj having a height of 1 µm or more were not found for Comparative Example. The conversion efficiency was not less than 8.8% and not more than 12.1% (specifically 8.8%, 12.1%, 11.4% and 10.2%) in Examples 1 to 4 whereas the conversion efficiency was only 5.3% in Comparative Example.

From the above examination results and measurement results, it has been found that the conversion efficiency is significantly improved by scattering of projections 31pj. It has been found that for improvement of the conversion efficiency by scattering projections 31pj, it is sufficient that the ratio of the amount of substance of the I-B group element to the amount of substance of the III-B group element (molar ratio, herein a value obtained by dividing the amount of substance of Cu by the total value of the amounts of substance of In and Ga) is less than 1. In other words, it has been found that, it is sufficient that a raw material solution containing the III-B group element such as In and Ga in an amount of substance greater than the amount of substance of the I-B element such as Cu is prepared.

Further, it has been found that for a good conversion efficiency of 10% or more to be achieved in the photoelectric conversion device, it is sufficient that a raw material solution is prepared such that a value obtained by dividing the amount of substance of Cu by the total value of the amounts of substance of In and Ga is in a range of approximately not less than 0.7 and not more than 0.9 as in Examples 2 to 4. In other words, it has been found that, it is sufficient that the ratio (molar ratio) of the amount of substance of the I-B group element to the amount of substance of the III-B group element in the raw material solution is in a range of approximately not less than 0.7 and not more than 0.9.

### <(4) Modified Examples>

The present invention is not limited to the embodiments described above, but various changes, modifications and the like can be made without departing from the spirit of the present invention.

For example, in one embodiment described above, a raw material solution was prepared by dissolving raw metals of Cu, In, Ga, and Se directly in a mixed solvent prepared by dissolving phenylselenol at a ratio of 100 mol% to aniline, but the present invention is not limited thereto. For example, one complex containing all elements for forming CIGS, such as Cu, In, Ga, and Se, may be dissolved in an organic solvent to prepare a raw material solution. Two or more complexes containing a plurality of elements for forming CIGS such as Cu, In, Ga, and Se, with the elements divided among the complexes, may be dissolved in an organic solvent to prepare a raw material solution. Further, a raw material solution in which fine particles of a selenide such as gallium serinide are dispersed may be used. That is, as the raw material solution for forming the light absorbing layer 31, a solution containing various kinds of elements to form the light absorbing layer 31 in various forms can be employed.

### DESCRIPTION OF SYMBOLS

- 1: substrate
- 2: lower electrode layer
- 3: photoelectric conversion layer
- 4: upper electrode layer
- 5: grid electrode
- 10: photoelectric conversion cell
- 21: photoelectric conversion device
- 31: light absorbing layer
- 31ft: reference surface
- 31op: opening
- 31ph: pinhole
- 31pj: projection
- 32: buffer layer
- 45: connector

## Claims

1. A photoelectric conversion device comprising:
a first semiconductor layer; and
a second semiconductor layer, wherein
the first semiconductor layer includes one principal surface on which a plurality of projections are scattered, includes a I-III-VI group compound semiconductor, and has a first conductivity type,
the second semiconductor layer is disposed on the one principal surface, has a thickness in a normal direction of the one principal surface, and has a second conductivity type different from the first conductivity type, and
a first distance along which each of the projections is projected in the normal direction is longer than a second direction along which the second semiconductor layer is provided in the normal direction.

2. The photoelectric conversion device according to claim 1, wherein each of the projections contains a III-VI group compound.

3. The photoelectric conversion device according to claim 1 or 2, wherein the first distance is longer than a wavelength of visible light.

4. A method for manufacturing a photoelectric conversion device, comprising the steps of:
forming a film by applying a raw material solution onto an electrode layer; and
forming a semiconductor layer by heat-treating the film, wherein
the raw material solution includes a Lewis-basic organic compound, an organic compound containing a chalcogen element, a I-B group element, and a III-B group element which has an amount of substance greater than that of the I-B group element, and
the semiconductor layer includes one principal surface on which a plurality of projections are scattered, and includes a I-III-VI group compound semiconductor.
